# EUROPEAN PATENT SPECIFICATION

(11) **EP 3 957 620 B1**
(45) Date of publication and mention of the grant of the patent: **12.11.2025**
(21) Application number: 21191670.5
(22) Date of filing: 17.08.2021
(51) Int. Cl.: C04B 35/573, C04B 35/628, C04B 35/80, C23C 16/34, C23C 16/36

(54) **METHOD OF MAKING A CERAMIC MATRIX COMPOSITE THAT EXHIBITS MOISTURE AND ENVIRONMENTAL RESISTANCE**
VERFAHREN ZUR HERSTELLUNG EINES KERAMIKMATRIXVERBUNDES MIT FEUCHTIGKEITS- UND UMWELTBESTÄNDIGKEIT
PROCÉDÉ DE FABRICATION DE COMPOSITE À MATRICE CÉRAMIQUE PRÉSENTANT UNE RÉSISTANCE À L'HUMIDITÉ ET AUX INTEMPÉRIES

(30) Priority: 19.08.2020 US 202016997094
(43) Date of publication of application: 23.02.2022
(73) Proprietor: Rolls-Royce High Temperature Composites Inc, Cypress, CA 90630 (US)
(72) Inventor: Kidd, Richard, Rancho Palos Verdes, 90275 (US); Shim, Sungbo, Irvine, 92620 (US); Kranjc, Kelly, Irvine, 92612 (US); Shinavski, Robert, Mission Viejo, 92691 (US)
(74) Representative: Pfenning, Meinig & Partner mbB

(56) References cited:
- EP-A1- 1 640 352
- US-A- 5 234 609
- US-A- 5 593 728
- US-A1- 2014 272 373
- LE GALLET S ET AL: "Microstructural and microtextural investigations of boron nitride deposited from BCl"3-NH"3-H"2 gas mixtures", JOURNAL OF THE EUROPEAN CERAMIC SOCIETY, ELSEVIER, AMSTERDAM, NL, vol. 24, no. 1, 1 January 2004 (2004-01-01), pages 33 - 44, XP004452654, ISSN: 0955-2219, DOI: 10.1016/S0955-2219(03)00126-2

## Description

### TECHNICAL FIELD

The present disclosure relates generally to the fabrication of ceramic matrix composites (CMCs) and more particularly to fabricating a CMC with good moisture and environmental resistance as well as favorable mechanical properties.

### BACKGROUND

Ceramic matrix composites, which include ceramic fibers embedded in a ceramic matrix, exhibit a combination of properties that make them promising candidates for industrial applications, such as gas turbine engines, that demand excellent thermal and mechanical properties along with low weight. A ceramic matrix composite that includes a silicon carbide matrix reinforced with silicon carbide fibers may be referred to as a silicon carbide/silicon carbide composite or SiC/SiC composite. Fabrication of a SiC/SiC composite may include slurry and melt infiltration steps to densify a silicon carbide fiber preform. Prior to the infiltration steps, the fibers making up the silicon carbide preform may be coated with one or more materials to protect the fibers and/or improve the performance of the final densified composite.
EP 1 640 352 A1 discloses a method for manufacturing a ceramic matrix composite article. The method includes providing a plurality of ceramic fiber tows. The method further includes depositing a coating comprising a layer of boron nitride, a layer of silicon-doped boron nitride, a layer of silicon nitride, and a layer of carbon. The method further includes assembling the coated fiber tows into a plurality of plies of ceramic cloth. The method further includes laying up the plies of ceramic cloth into an article form. The method further includes densifying the article form using a material selected from the group consisting of ceramic particulates, ceramic precursor resins, and combinations thereof and using a method selected from the group consisting of slurry casting, resin transfer molding, vacuum impregnation, and combinations thereof. The method further includes infiltrating the article form with at least silicon to form a ceramic matrix composite article with a substantially continuous matrix.

### BRIEF DESCRIPTION OF THE DRAWINGS

The embodiments may be better understood with reference to the following drawing(s) and description. The components in the figures are not necessarily to scale. Moreover, in the figures, like-referenced numerals designate corresponding parts throughout the different views.
FIG. 1 is a high resolution transmission electron microscopy (TEM) image providing a cross-sectional view of a portion of a silicon carbide fiber coated with functional layers; scale bar is 500 nm.
FIG. 2. is an electron energy loss spectroscopy (EELS) line scan showing element (*e.g.*, B, C, N, Si) profiles, where at.% of the element is plotted versus depth or distance in nanometers.
FIG. 3 is a flow chart showing exemplary steps of the method.
FIG. 4 is a data plot showing results from moisture exposure testing of fiber preform specimens coated with SiBN at different doping levels.

### DETAILED DESCRIPTION

A method of making a ceramic matrix composite (CMC) that may exhibit improved moisture and environmental resistance without a loss in material performance is defined in claim 1. The method includes controllably depositing a sequence of coatings or layers, each having a particular function, on silicon carbide fibers that serve as reinforcements in the final CMC. In particular, a moisture-tolerant layer is deposited on a diffusion barrier layer to form a compliant multilayer that protects the underlying silicon carbide fibers from environmental degradation in use. After the layers are applied, a fiber preform comprising the silicon carbide fibers may undergo slurry infiltration and then melt infiltration to form the final CMC.

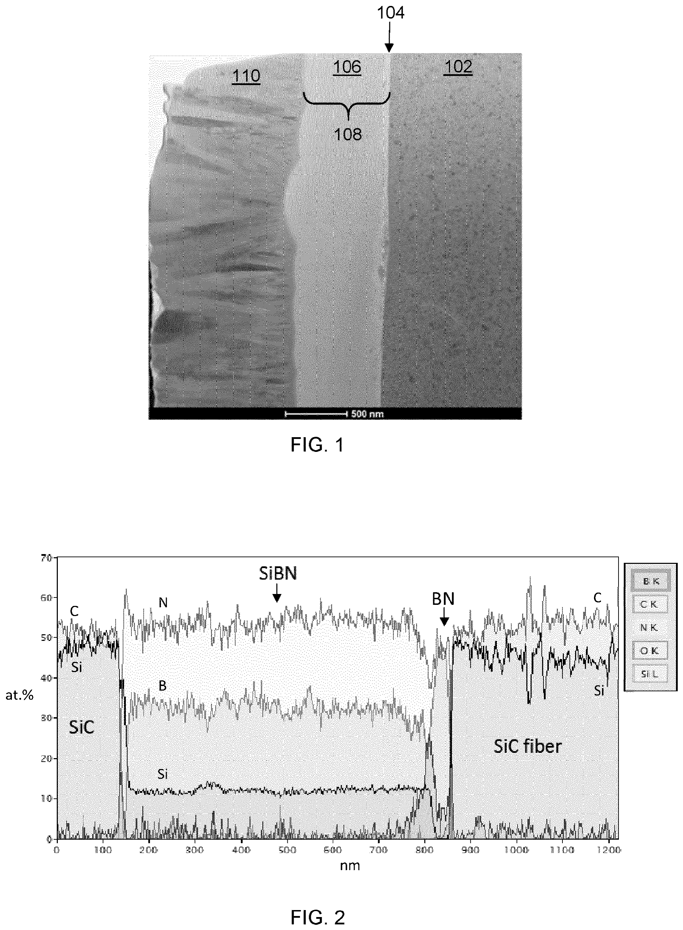

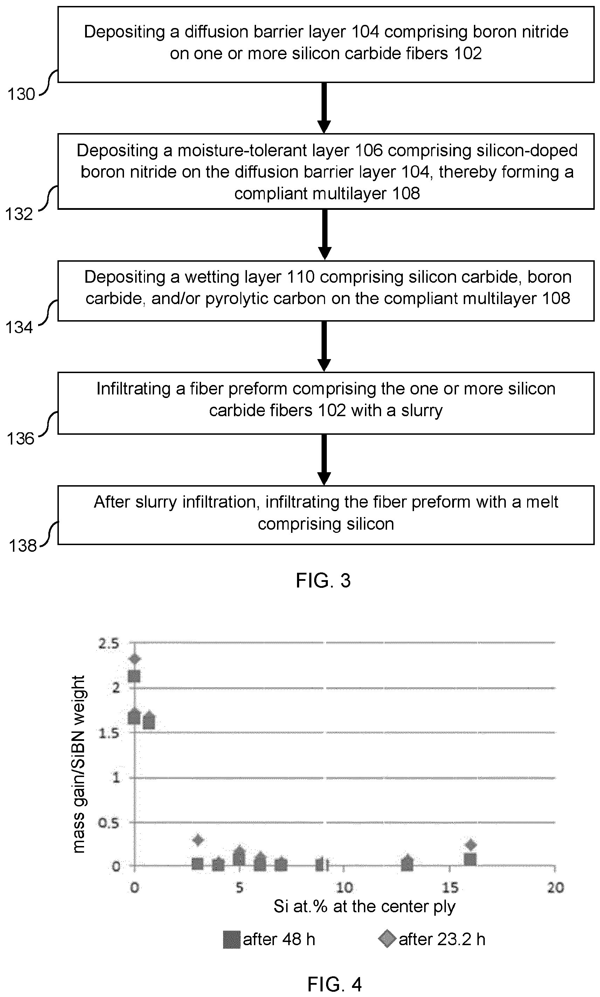

FIG. 1 is a high resolution transmission electron microscopy (TEM) image showing a cross-section of an exemplary silicon carbide fiber that includes a sequence of functional layers or coatings, and FIG. 3 provides a flow chart of the method. Referring to FIGs. 1 and 3, the method entails depositing 130 a diffusion barrier layer 104 comprising boron nitride on one or more silicon carbide fibers 102, which may be referred to as "the silicon carbide fibers." The diffusion barrier layer 104 may help to ensure a weak fiber-matrix interface in the finished CMC and promote matrix crack deflection, thereby improving fracture toughness. Next, a moisture-tolerant layer 106 comprising silicon-doped boron nitride is deposited 132 on the diffusion barrier layer 104, thereby forming a compliant multilayer 108 that includes the moisture-tolerant and diffusion barrier layers 106,104. The diffusion barrier layer may prevent the silicon carbide fibers 102 and the moisture-tolerant layer 106 from interdiffusing and forming a strong bond, whether during subsequent thermal processing or in use. The diffusion barrier layer 104 is nanoscale in thickness, namely the thickness is not greater than about 100 nm; at higher thicknesses, the diffusion barrier layer 104 may show the moisture instability that is sometimes observed with thicker boron nitride coatings in silicon carbide/silicon carbide composites. The moisture-tolerant layer 106 has a thickness from about 5 to about 300 times the thickness of the diffusion barrier layer 104. A wetting layer 110 comprising silicon carbide, boron carbide (e.g., BₓC, where 0≤x≤4), and/or pyrolytic carbon is deposited 134 on the compliant multilayer layer 108. In some examples, prior to depositing the wetting layer 110, a barrier layer designed to resist wetting by molten silicon may be deposited on the moisture-tolerant layer 106, as discussed further below. After depositing the wetting layer 110, a fiber preform comprising the silicon carbide fibers 102 is infiltrated 136 with a slurry that may include ceramic (e.g., silicon carbide) particles in a carrier fluid. Following slurry infiltration, the fiber preform is infiltrated 138 with a melt comprising silicon, and upon cooling of the melt, a dense CMC which includes the silicon carbide fibers in a ceramic matrix comprising silicon carbide may be formed.

The addition of the moisture-tolerant layer 106 comprising silicon-doped boron nitride may not only enhance the environmental resistance of the CMC in use, but also may help to protect the underlying diffusion barrier layer 104 and silicon carbide fibers 102 from silicon attack during melt infiltration. As indicated above, the thickness of the moisture-tolerant layer 106 is from 5 to 100 times that of the diffusion barrier layer 104. For example, the thickness of the moisture-tolerant layer 106 may lie in a range from about 0.4 to about 3 microns, or from about 1.5 microns to about 3 microns, while the thickness of the diffusion barrier layer 104 lies in a range from about 0.01 micron to about 0.10 micron, e.g. from about 0.05 micron to about 0.10 micron. Diffusion barrier layers having a thickness at the higher end of the range (e.g., about 0.05 micron (50 nm) or higher) may be associated with increased fracture toughness and failure strain. The concentration of silicon in the silicon-doped boron nitride lies in a range from about 2 at.% to about 30 at.%.

Each of the layers deposited on the silicon carbide fibers 102, which may be referred to as "functional layers," is described below in order of deposition. It is noted that deposition of the functional layers on the silicon carbide fibers 102 may be carried out using chemical vapor infiltration (CVI) methods. Generally speaking, CVI entails flowing gaseous reagents at an elevated temperature through a furnace or reaction chamber containing one or more porous specimens to be coated. The one or more porous specimens may comprise any arrangement of the silicon carbide fibers 102 (e.g., a fiber preform and/or fiber tows, as discussed below), where interstices between adjacent silicon carbide fibers 102 may be understood to constitute pores. During CVI, the gaseous reagents may infiltrate the porous specimen(s) (e.g., the fiber preform and/or the fiber tows) and chemically react to form a deposit, coating or layer on exposed surfaces of the silicon carbide fibers 102. The porous specimen(s) may be untooled or constrained with a tool during deposition. A suitable tool may include through-holes for passage of the gaseous reagents and may be formed of a chemically inert and/or refractory material, such as graphite or silicon carbide, which is stable at the elevated temperatures at which deposition takes place. Through-holes in the tool may have a diameter or width sized to allow for a sufficient flow of gaseous reactants into the porous specimen during CVI. The tool may have a single-piece or multi-piece construction suitable for constraining the porous specimen(s) in a desired configuration and for easy removal after deposition of the coatings.

To deposit the diffusion barrier layer 104 comprising boron nitride, the silicon carbide fibers 102 are exposed to a gaseous atmosphere comprising a flow of nitrogen-containing gas, such as ammonia, and a flow of boron-containing gas, such as boron trichloride, at a temperature in a range from about 700°C to about 875°C. The gaseous atmosphere may further comprise a flow of a substantially inert carrier gas such as N₂ or H₂. In one example, the diffusion barrier layer 104 may comprise a crystalline (hexagonal) phase of the boron nitride, which is preferred since amorphous or turbostratic boron nitride is more likely to degrade upon exposure to moisture and/or oxygen at elevated temperatures. Crystallinity of the boron nitride may be promoted or ensured by exposure to atmospheric humidity and a heat treatment as described below, which may optionally take place during CVI of a successive layer. Deposition of the diffusion barrier layer 104 may take place over a time duration of 1-10 hours.

In a next step, to enhance moisture and environmental resistance, the moisture-tolerant layer 106 comprising silicon-doped boron nitride is deposited on the diffusion barrier layer 104. This entails incorporating a silicon-containing gas into the gaseous atmosphere used to form the underlying diffusion barrier layer 104 which includes flows of the nitrogen-containing gas and the boron-containing gas as described above along with a substantially inert carrier gas such as N₂ or H₂. Notably, it has been found that using H₂ as a carrier gas instead of N₂ may lead to a 50% increase in deposition rate of the silicon-doped boron nitride, and thus H₂ is preferred. A suitable silicon-containing gas may include methyltrichlorosilane (CH₃SiCl₃), trichlorosilane (HSiCl₃), dichlorosilane (H₂SiCl₂), silicon tetrachloride (SiCl₄), and/or silane (SiH₄). Typically, CVI of silicon-doped boron nitride is carried out at a temperature in a range from about 700°C to about 875°C. Deposition of the moisture-tolerant layer 106 may take place over a time duration of 10-70 hours.

In addition to serving as a compliant release layer, the diffusion barrier layer 104 may function as a diffusion barrier between carbon enrichment/non-stoichiometry of the silicon carbide fiber and/or residual carbon (sizing) char on the silicon carbide fibers 102 and the moisture-tolerant layer 106. To promote crystallinity of the diffusion barrier layer 104 (*e.g.*, formation of the hexagonal boron nitride phase) as mentioned above, the method may further include exposing the diffusion barrier layer 104 and/or the compliant multilayer 108 to atmospheric humidity, and then heat treating the diffusion barrier layer 104 and/or the compliant multilayer 108 at a temperature in a range from about 900°C to about 1150°C, preferably in an inert atmosphere.

As described above, an optional barrier layer having a high contact angle with molten silicon may be deposited on the compliant multilayer 108 prior to deposition of the wetting layer 110. For the barrier layer to serve as an effective chemical barrier, it is preferred that the contact angle is at least about 45°. Accordingly, the barrier layer comprises silicon nitride or silicon nitrocarbide, such as SiₓN_{y}C_{z}, which both may exhibit the requisite contact angle with molten silicon. In one example, 0.1 < x < 0.697, 0.3 < y < 0.6, and 0.003 < z < 0.33; that is, the barrier layer may include carbon at a concentration from about 0.3 at.% to 33 at.% and nitrogen at a concentration from about 30 at.% to 60 at.%, with a balance of silicon and any incidental impurities. Silicon nitrocarbide may be understood to comprise a mixture of silicon carbide (SiC), silicon nitride (Si₃N₄), and/or carbon (C). The silicon nitrocarbide may be amorphous and may remain amorphous during CVI processing due at least in part to the presence of carbon, which may inhibit or prevent crystallization. Consequently, crystallization-induced shrinkage cracking of the barrier layer, a problem that can be associated with amorphous silicon nitride, which does not include any appreciable amount of carbon, may be beneficially avoided. If the barrier layer comprises silicon nitride (*e.g.*, Si₃N₄), crystalline silicon nitride is preferred, and more particularly crystalline silicon nitride which is devoid of cracks. The barrier layer may be deposited to have a thickness in a range from about 0.005 micron to about 2 microns, or more preferably in a range from about 0.3 micron to about 1 micron.

The positioning of the barrier layer between the compliant multilayer 108 and the wetting layer 110 may lead to improvements in the fabrication and properties of the CMC. Previous work has shown that molten silicon can diffuse through a silicon carbide wetting or rigidization layer and chemically attack the underlying diffusion barrier layer and/or the silicon carbide fibers. Here, the barrier layer may be deposited prior to the rigidization or wetting layer 110 and thus may be uniquely positioned to provide a chemical barrier against silicon attack without sacrificing the wettability desired for the wetting layer 110.

Deposition of the barrier layer on the compliant multilayer 108 may comprise exposing the compliant multilayer 108 to a gaseous atmosphere comprising a flow of a silicon-containing gas and a flow of a nitrogen-containing gas, which may entail halting the flow of the boron-containing gas into the gaseous atmosphere while the nitrogen- and/or silicon-containing gases continue to flow as described above, at a temperature in a range from about 700°C to about 1000°C. It may be beneficial to halt the flow of the boron-containing gas for 5-30 minutes before the flows of the nitrogen- and silicon-containing gases are halted. If the intent is to deposit a barrier layer comprising silicon nitrocarbide, instead of silicon nitride, then a flow of a carbon-containing gas may be included in the gaseous atmosphere. The carbon-containing gas may be the same as or different from the silicon-containing gas or the nitrogen-containing gas. In other words, the silicon-containing gas or the nitrogen-containing gas may also include carbon. One example of a silicon-containing gas that includes carbon is methyltrichlorosilane (CH₃SiCl₃), as mentioned above, which is also known as MTS. In addition to the silicon-, nitrogen- and/or carbon-containing gases, which may individually or collectively be referred to as reactive gas(es), the gaseous atmosphere may further include a flow of a carrier gas, which as indicated above may be a nonreactive or reactive gas and which may be selected from N₂ and H₂.

After deposition of the optional barrier layer, the wetting layer 110, which may in some cases function also as a rigidization layer, may be deposited. According to the invention, the wetting layer 110 comprises silicon carbide, boron carbide, and/or pyrolytic carbon. Deposition may entail CVI utilizing a flow of a silicon-containing gas or a boron-containing gas that further contains carbon, such as, in one example, the MTS mentioned above. Prior to CVI of the wetting layer 110, the flow of all gases except the carrier gas (*e.g.*, H₂ or N₂) may be halted and the furnace may be cooled. Typically, the wetting layer 110 has a thickness in a range from about 0.5 micron to about 10 microns. CVI of the wetting layer 110 may be carried out from about 1 hour to about 60 hours, and generally at a temperature in a range from about 600°C to about 1500°C.

The silicon carbide fibers 102 that undergo coating may be arranged in a fiber tow, unidimensional tape, braid, ply, and/or woven fabric (e.g., 2D woven, 3D woven and/or 2.5D woven), and may further be part of a fiber preform that has a predetermined shape, such as an airfoil shape. The fiber preform is typically produced in a lay-up process from the plies, woven fabrics and/or tapes and may be described as a three-dimensional framework of the silicon carbide fibers or fiber tows. Typically, the silicon carbide fibers 102 are assembled into a fiber preform prior to CVI.

After deposition of the functional layers, the silicon carbide fibers may be referred to as coated silicon carbide fibers, and the fiber preform may be referred to as a rigidized preform. Deposition of the functional layers may be followed by slurry infiltration to impregnate the rigidized preform with matrix precursors, forming what may be referred to as an impregnated fiber preform. A suitable slurry may include ceramic particles (*e.g*., particulate silicon carbide) and/or particulate reactive elements (*e.g.*, elements reactive with molten silicon or a molten silicon alloy), such as carbon, in an aqueous or organic liquid. The slurry may further include a carbonaceous resin, such as phenolic or furfuryl alcohol. In some cases, the carbonaceous resin may be separately infiltrated into the rigidized preform after slurry infiltration, or may not be used at all. If a carbonaceous resin is employed, one or more additional steps, such as curing and/or pyrolysis, may be carried out to convert the resin to carbon. Typically, the impregnated fiber preform comprises a loading level of particulate matter, including ceramic particles and particulate reactive elements, from about 40 vol.% to about 60 vol.%, with the remainder being porosity. The method may further comprise infiltrating the fiber preform with molten material (*e.g.*, molten silicon or a molten silicon alloy) followed by cooling to form a densified ceramic matrix composite. Due to the presence of the barrier coating, the silicon carbide fibers and the diffusion barrier layer (or compliant multilayer) may be protected from attack by molten silicon.

During melt infiltration, the molten material infiltrated into the rigidized and/or impregnated fiber preform may consist essentially of silicon (*e.g*., elemental silicon and any incidental impurities) or may comprise a silicon-rich alloy. Melt infiltration may be carried out at a temperature at or above the melting temperature of silicon or the silicon alloy which is infiltrated. Thus, the temperature for melt infiltration is typically in a range from about 1380°C to about 1700°C. In one example, a ramp rate from an intermediate temperature of about 800°C to a temperature above about 1380°C may be less than about 10°C/min. A suitable time duration for melt infiltration may be from 15 minutes to four hours, depending in part on the size and complexity of the ceramic matrix composite to be formed. A ceramic matrix is formed from ceramic particles as well as ceramic reaction products created from reactions between the molten material and any other particles (*e.g*., carbon particles, refractory metal particles) in the fiber preform. Preferably, the final ceramic matrix composite is substantially devoid of closed porosity. In some cases, the ceramic matrix composite may form part or all of a gas turbine engine component, such as a blade or vane.

### Example

5HS Hi-Nicalon Type S fabric is preformed into a 16.5 cm x 17.8 cm x 0.508 cm (6.5" x 7" x 0.200") panel, tooled into a graphite tool with diffusion holes, and loaded in a furnace. After evacuation, the furnace is heated to 1000°C for 5 mins to 1 hour for heat treatment of the panel/fiber preform. The furnace temperature is then cooled to 750 to 850°C and flows of N₂, BCl₃, and NH₃ are introduced for three hours to apply a diffusion barrier layer comprising boron nitride on the silicon carbide fibers of the preform. Next, a flow of MTS is added to the gaseous atmosphere for 25 to 40 hours, and a moisture tolerant layer comprising silicon-doped boron nitride is deposited on the diffusion barrier layer, forming a compliant multilayer. In a next step, the BCl₃ is shut off for 15 minutes while the flows of MTS, NH₃ and N₂ continue to form a silicon nitrocarbide barrier layer. Finally, the flow of all gases except N₂ are halted and the furnace is cooled. Subsequently, a SiC layer is deposited to form a rigidization or wetting layer. The preform may be slurry infiltrated with a SiC-containing slurry followed by melt infiltration with silicon or a silicon alloy to form a SiC/SiC composite.

The microstructure of the functional coatings on the silicon carbide fiber is shown by the transmission electron microscopy (TEM) image of FIG. 1 in conjunction with an electron energy loss spectroscopy (EELS) line scan that provides elemental profiles, as shown in FIG. 2. The data reveal that the exemplary sample includes a moisture-tolerant layer comprising silicon-doped boron nitride ("SiBN") containing about 11-12 at.% silicon. The thickness of the SiBN layer is approximately 0.65 micron (650 nm), and the thickness of the diffusion barrier layer comprising BN is approximately 0.05 micron (50 nm).

FIG. 4 shows a data plot of moisture exposure test results from fiber preform specimens coated with SiBN at different doping levels. The moisture testing was conducted at 65°C and 95% relative humidity. As indicated in the plot, weight gain from hydrolysis significantly decreases with the silicon dopant level is greater than about 3 at.%.

To clarify the use of and to hereby provide notice to the public, the phrases "at least one of <A>, <B>, ... and <N>" or "at least one of <A>, <B>, ... <N>, or combinations thereof" or "<A>, <B>, ... and/or <N>" are defined by the Applicant in the broadest sense, superseding any other implied definitions hereinbefore or hereinafter unless expressly asserted by the Applicant to the contrary, to mean one or more elements selected from the group comprising A, B, ... and N. In other words, the phrases mean any combination of one or more of the elements A, B, ... or N including any one element alone or the one element in combination with one or more of the other elements which may also include, in combination, additional elements not listed. Unless otherwise indicated or the context suggests otherwise, as used herein, "a" or "an" means "at least one" or "one or more."

While various embodiments have been described, it will be apparent to those of ordinary skill in the art that many more embodiments and implementations are possible. Accordingly, the embodiments described herein are examples, not the only possible embodiments and implementations.

## Claims

1. A method of making a ceramic matrix composite that exhibits moisture and environmental resistance, the method comprising:
depositing (130) a diffusion barrier layer (104) with a thickness in a range from about 0.01 micron to about 0.10 micron comprising boron nitride on silicon carbide fibers (102), the depositing comprising exposing the silicon carbide fibers (102) to a gaseous atmosphere comprising a flow of a nitrogen-containing gas and a flow of a boron-containing gas at a temperature in a range from about 700°C to about 875°C;
after depositing (130) the diffusion barrier layer (104), introducing a flow of silicon-containing gas into the gaseous atmosphere, thereby depositing (132) a moisture-tolerant layer (106) comprising silicon-doped boron nitride on the diffusion barrier layer (104), wherein the moisture-tolerant layer (106) includes silicon at a concentration from about 2 at.% to about 30 at.%, a thickness of the moisture-tolerant layer (106) being from about 5 to about 300 times a thickness of the diffusion barrier layer (104), thereby forming a compliant multilayer (108) including the moisture-tolerant layer (106) and the diffusion barrier layer (104);
depositing (134) a wetting layer (110) comprising silicon carbide, boron carbide, and/or pyrolytic carbon on the compliant multilayer (108) layer;
after depositing (134) the wetting layer (110), infiltrating (136) a fiber preform comprising the silicon carbide fibers (102) with a slurry; and
after infiltration with the slurry (136), infiltrating the fiber preform with a melt comprising silicon (138) and then cooling the melt, thereby forming a ceramic matrix composite.

2. The method of claim 1, wherein the thickness of the moisture-tolerant layer (106) is from about 10 to 100 times the thickness of the diffusion barrier layer (104) and/or is in a range from about 0.4 micron to about 3 microns.

3. The method of claim 1 or 2, wherein the diffusion barrier layer (104) comprises a crystalline phase of the boron nitride, wherein preferably the crystalline phase comprises a hexagonal phase.

4. The method of claim 3, further comprising:
exposing the compliant multilayer (108) to atmospheric humidity; and
heat treating the compliant multilayer (108) at a temperature in a range from about 900°C to about 1150°C, thereby forming the crystalline phase.

5. The method of any one of claims 1-4, wherein depositing (130) the diffusion barrier layer (104) comprises exposing the silicon carbide fibers (102) to a gaseous atmosphere comprising:
a flow of a carrier gas selected from N₂ and H₂, preferably a flow of a carrier gas carrier gas comprising H₂ at a temperature in a range from about 700°C to about 875°C.

6. The method of any one of claims 1 to 5, wherein the silicon-containing gas is selected from the group consisting of methyltrichlorosilane (CH₃SiCl₃), trichlorosilane (HSiCl₃), dichlorosilane (H₂SiCl₂), silicon tetrachloride (SiCl₄), and silane (SiH₄).

7. The method of any one of claims 1-6, wherein the diffusion barrier layer (104) is deposited (130) over a time duration from about one hour to about 10 hours.

8. The method of any one of claims 1-7, wherein the moisture-tolerant layer is deposited (132) over a time duration from about 10 hours to about 70 hours.

9. The method of any one of claims 1-8, further comprising, prior to depositing (134) the wetting layer (110), depositing a barrier layer having a high contact angle with molten silicon on the compliant multilayer (108), wherein the barrier layer comprises silicon nitrocarbide or silicon nitride.

10. The method of any one of claims 1-9, further comprising, prior to coating the silicon carbide fibers (102) with the diffusion barrier layer (104), forming the fiber preform comprising the silicon carbide fibers (102).

11. A fiber preform for fabricating a ceramic matrix composite, the fiber preform comprising:
silicon carbide fibers (102) coated with a plurality of functional layers, the functional layers including:
a diffusion barrier layer (104) with a thickness in a range from about 0.01 micron to about 0.10 micron comprising boron nitride deposited on the silicon carbide fibers (102), wherein the diffusion barrier layer (104) is deposited by exposing the silicon carbide fibers (102) to a gaseous atmosphere comprising a flow of a nitrogen-containing gas and a flow of a boron-containing gas at a temperature in a range from about 700°C to about 875°C;
a moisture-tolerant layer (106) comprising silicon-doped boron nitride deposited on the diffusion barrier layer (104), wherein the moisture-tolerant layer (106) is deposited by introducing, after the diffusion barrier layer (104) is deposited, a flow of silicon-containing gas into the gaseous atmosphere, wherein the moisture-tolerant layer (106) includes silicon at a concentration from about 2 at.% to about 30 at.%, a thickness of the moisture-tolerant layer (106) being from about 5 to about 300 times a thickness of the diffusion barrier layer (104), the moisture-tolerant layer (106) and the diffusion barrier layer (104) together defining a compliant multilayer (108); and
a wetting layer (110) comprising silicon carbide, boron carbide, and/or pyrolytic carbon deposited on the compliant multilayer (108) layer.

12. A fiber preform for fabricating a ceramic matrix composite, according to claim 11, wherein the thickness of the diffusion barrier layer (104) is in a range from about 0.05 micron to about 0.10 micron.

13. A fiber preform for fabricating a ceramic matrix composite, according to claim 11 or 12, wherein the thickness of the moisture-tolerant layer (106) is in a range from about 0.4 micron to about 3 microns.

## Patentansprüche

1. Verfahren zur Herstellung eines Keramikmatrix-Verbundwerkstoffs, der Feuchtigkeits- und Umweltbeständigkeit aufweist, wobei das Verfahren umfasst:
Abscheiden (130) einer Diffusionssperrschicht (104) mit einer Dicke in einem Bereich von etwa 0,01 Mikron bis etwa 0,10 Mikron, die Bornitrid umfasst, auf Siliziumkarbidfasern (102), wobei das Abscheiden das Aussetzen der Siliziumkarbidfasern (102) einer Gasatmosphäre, die einen Strom eines stickstoffhaltigen Gases und einen Strom eines borhaltigen Gases umfasst, bei einer Temperatur in einem Bereich von etwa 700°C bis etwa 875°C umfasst;
nach dem Abscheiden (130) der Diffusionssperrschicht (104), Einleiten eines Stroms von siliziumhaltigem Gas in die Gasatmosphäre, wodurch eine feuchtigkeitstolerante Schicht (106), die siliziumdotiertes Bornitrid umfasst, auf der Diffusionssperrschicht (104) abgeschieden wird (132), wobei die feuchtigkeitstolerante Schicht (106) Silizium in einer Konzentration von etwa 2 at.% bis etwa 30 at. % enthält, wobei eine Dicke der feuchtigkeitstoleranten Schicht (106) etwa das 5- bis etwa 300-fache einer Dicke der Diffusionssperrschicht (104) beträgt, wodurch eine nachgiebige Mehrfachschicht (108) gebildet wird, die die feuchtigkeitstolerante Schicht (106) und die Diffusionssperrschicht (104) enthält;
Abscheiden (134) einer Benetzungsschicht (110), die Siliziumkarbid, Borkarbid und/oder pyrolytischen Kohlenstoff umfasst, auf der nachgiebigen Mehrfachschicht (108);
nach dem Abscheiden (134) der Benetzungsschicht (110), Infiltrieren (136) einer Faservorform, die die Siliziumkarbidfasern (102) umfasst, mit einer Aufschlämmung; und
nach dem Infiltrieren mit der Aufschlämmung (136), Infiltrieren der Faservorform mit einer Silizium enthaltenden Schmelze (138) und anschließendes Abkühlen der Schmelze, wodurch ein Keramikmatrix-Verbundwerkstoff gebildet wird.

2. Verfahren nach Anspruch 1, wobei die Dicke der feuchtigkeitstoleranten Schicht (106) etwa das 10- bis 100-fache der Dicke der Diffusionssperrschicht (104) beträgt und/oder in einem Bereich von etwa 0,4 Mikron bis etwa 3 Mikron liegt.

3. Verfahren nach Anspruch 1 oder 2, wobei die Diffusionssperrschicht (104) eine kristalline Phase des Bornitrids umfasst, wobei die kristalline Phase vorzugsweise eine hexagonale Phase umfasst.

4. Verfahren nach Anspruch 3, ferner umfassend:
Aussetzen der nachgiebigen Mehrfachschicht (108) gegenüber Luftfeuchtigkeit; und
Wärmebehandeln der nachgiebigen Mehrfachschicht (108) bei einer Temperatur in einem Bereich von etwa 900°C bis etwa 1150°C, wodurch die kristalline Phase gebildet wird.

5. Verfahren nach einem der Ansprüche 1-4, wobei das Abscheiden (130) der Diffusionssperrschicht (104) das Aussetzen der Siliziumkarbidfasern (102) einer Gasatmosphäre umfasst, umfassend:
einen Strom eines Trägergases, ausgewählt aus N₂ und H₂, vorzugsweise einen Strom eines Trägergases, das H₂ enthält, bei einer Temperatur im Bereich von etwa 700°C bis etwa 875°C.

6. Verfahren nach einem der Ansprüche 1 bis 5, wobei das siliziumhaltige Gas ausgewählt ist aus der Gruppe bestehend aus Methyltrichlorsilan (CH₃SiCl₃), Trichlorsilan (HSiCl₃), Dichlorsilan (H₂SiCl₂), Siliziumtetrachlorid (SiCl₄) und Silan (SiH₄).

7. Verfahren nach einem der Ansprüche 1 bis 6, wobei die Diffusionssperrschicht (104) über eine Zeitdauer von etwa einer Stunde bis etwa 10 Stunden abgeschieden (130) wird.

8. Verfahren nach einem der Ansprüche 1 bis 7, wobei die feuchtigkeitstolerante Schicht über eine Zeitdauer von etwa 10 Stunden bis etwa 70 Stunden aufgebracht wird (132).

9. Verfahren nach einem der Ansprüche 1 bis 8, wobei vor dem Aufbringen (134) der Benetzungsschicht (110) eine Sperrschicht mit einem hohen Kontaktwinkel mit geschmolzenem Silizium auf der nachgiebigen Mehrfachschicht (108) aufgebracht wird, wobei die Sperrschicht Siliziumnitrokarbid oder Siliziumnitrid umfasst.

10. Verfahren nach einem der Ansprüche 1 bis 9, ferner umfassend, vor dem Beschichten der Siliziumkarbidfasern (102) mit der Diffusionssperrschicht (104), Bilden der Faservorform, die die Siliziumkarbidfasern (102) umfasst.

11. Faservorform zur Herstellung eines Keramikmatrix-Verbundwerkstoffs, wobei die Faservorform Folgendes umfasst:
Siliziumkarbidfasern (102), die mit einer Mehrzahl von Funktionsschichten beschichtet sind, wobei die Funktionsschichten umfassen:
eine Diffusionssperrschicht (104) mit einer Dicke in einem Bereich von etwa 0,01 Mikron bis etwa 0,10 Mikron, die Bornitrid umfasst, das auf den Siliziumkarbidfasern (102) abgeschieden ist, wobei die Diffusionssperrschicht (104) abgeschieden wird, indem die Siliziumkarbidfasern (102) einer Gasatmosphäre ausgesetzt werden, die einen Strom eines stickstoffhaltigen Gases und einen Strom eines borhaltigen Gases bei einer Temperatur in einem Bereich von etwa 700°C bis etwa 875°C umfasst;
eine feuchtigkeitstolerante Schicht (106), die siliziumdotiertes Bornitrid umfasst, das auf der Diffusionssperrschicht (104) abgeschieden ist, wobei die feuchtigkeitstolerante Schicht (106) abgeschieden wird, indem nach dem Abscheiden der Diffusionssperrschicht (104) ein Strom von siliziumhaltigem Gas in die Gasatmosphäre eingeleitet wird, wobei die feuchtigkeitstolerante Schicht (106) Silizium in einer Konzentration von etwa 2 at.% bis eine 30 at. % enthält, wobei eine Dicke der feuchtigkeitstoleranten Schicht (106) etwa das 5- bis etwa 300-fache der Dicke der Diffusionssperrschicht (104) beträgt, wobei die feuchtigkeitstolerante Schicht (106) und die Diffusionssperrschicht (104) zusammen eine nachgiebige Mehrfachschicht (108) bilden; und
eine Benetzungsschicht (110), die Siliziumkarbid, Borkarbid und/oder pyrolytischen Kohlenstoff umfasst, der auf der nachgiebigen Mehrfachschicht (108) abgeschieden ist.

12. Faservorform zur Herstellung eines Keramikmatrix-Verbundwerkstoffs nach Anspruch 11, wobei die Dicke der Diffusionssperrschicht (104) in einem Bereich von etwa 0,05 Mikron bis etwa 0,10 Mikron liegt.

13. Faservorform zur Herstellung eines Keramikmatrix-Verbundwerkstoffs nach Anspruch 11 oder 12, wobei die Dicke der feuchtigkeitstoleranten Schicht (106) in einem Bereich von etwa 0,4 Mikron bis etwa 3 Mikron liegt.

## Revendications

1. Procédé de fabrication d'un composite à matrice céramique qui montre une résistance à l'humidité et aux intempéries, le procédé consistant à :
déposer (130) une couche barrière de diffusion (104) avec une épaisseur dans une plage d'environ 0,01 micron à environ 0,10 micron comprenant du nitrure de bore sur des fibres de carbure de silicium (102), le dépôt comprenant l'étape consistant à exposer les fibres de carbure de silicium (102) à une atmosphère gazeuse comprenant un écoulement d'un gaz contenant de l'azote et un écoulement d'un gaz contenant du bore à une température dans une plage d'environ 700°C à environ 875°C;
après avoir déposé (130) la couche barrière de diffusion (104), introduisant un écoulement de gaz contenant du silicium dans l'atmosphère gazeuse, en déposant ainsi (132) une couche tolérant l'humidité (106) comprenant du nitrure de bore dopé au silicium sur la couche barrière de diffusion (104), dans laquelle la couche tolérant l'humidité (106) inclut du silicium à une concentration d'environ 2 % atomique à environ 30 % atomique, une épaisseur de la couche tolérant l'humidité (106) étant d'environ 5 à environ 300 fois une épaisseur de la couche barrière de diffusion (104), en formant ainsi une multicouche conforme (108) incluant la couche tolérant l'humidité (106) et la couche barrière de diffusion (104) ;
déposer (134) une couche de mouillage (110) comprenant du carbure de silicium, du carbure de bore et/ou du carbone pyrolytique sur la multicouche conforme (108) ;
après avoir déposé (134) la couche de mouillage (110), avoir infiltré (136) une préforme fibreuse comprenant les fibres de carbure de silicium (102) avec une suspension ; et
après infiltration avec la suspension (136), avoir infiltré la préforme fibreuse avec une matière fondue comprenant du silicium (138), puis avoir refroidi la matière fondue, formant ainsi un composite à matrice céramique.

2. Procédé selon la revendication 1, dans lequel l'épaisseur de la couche tolérant l'humidité (106) est d'environ 10 à 100 fois l'épaisseur de la couche barrière de diffusion (104) et/ou est dans une plage d'environ 0,4 micron à environ 3 microns.

3. Procédé selon la revendication 1 ou 2, dans laquelle la couche barrière de diffusion (104) comprend une phase cristalline du nitrure de bore, dans lequel de préférence la phase cristalline comprend une phase hexagonale.

4. Procédé selon la revendication 3, comprenant en outre les étapes consistant à :
exposer la multicouche conforme (108) à l'humidité atmosphérique ; et
traiter thermiquement la multicouche conforme (108) à une température dans une plage allant d'environ 900°C à environ 1 150°C, en formant ainsi la phase cristalline.

5. Procédé selon n'importe quelle revendication de 1 à 4, dans laquelle déposer(130) la couche barrière de diffusion (104) comprend l'étape consistant à exposer les fibres de carbure de silicium (102) à une atmosphère gazeuse comprenant :
un écoulement d'un gaz porteur choisi parmi N₂ et H₂, de préférence un écoulement d'un gaz porteur de gaz porteur comprenant H₂ à une température comprise dans une plage allant d'environ 700°C à environ 875°C.

6. Procédé selon n'importe quelle revendication de 1 à 5, dans laquelle le gaz contenant du silicium est choisi dans le groupe comprenant le méthyltrichlorosilane (CH₃SiCl₃), le trichlorosilane (HSiCl₃), le dichlorosilane (H₂SiCl₂), le tétrachlorure de silicium (SiCl₄) et le silane (SiH₄).

7. Procédé selon n'importe quelle revendication de 1 à 6, dans laquelle la couche barrière de diffusion (104) est déposée (130) sur une durée d'environ une heure à environ 10 heures.

8. Procédé selon n'importe quelle revendication de 1 à 7, dans laquelle la couche tolérant l'humidité est déposée (132) sur une durée d'environ 10 heures à environ 70 heures.

9. Procédé selon n'importe quelle revendication de 1 à 8, comprenant en outre, avant le dépôt (134) de la couche de mouillage (110), l'étape consistant à déposer une couche barrière présentant un angle de contact élevé avec le silicium fondu sur la multicouche conforme (108), dans laquelle la couche barrière comprend du nitrocarbure de silicium ou du nitrure de silicium.

10. Procédé selon n'importe quelle revendication de 1 à 9, comprenant en outre, avant de revêtir les fibres de carbure de silicium (102) avec la couche barrière de diffusion (104), l'étape consistant à former la préforme fibreuse comprenant les fibres de carbure de silicium (102).

11. Préforme fibreuse pour fabriquer un composite à matrice céramique, la préforme fibreuse comprenant :
des fibres de carbure de silicium (102) revêtues d'une pluralité de couches fonctionnelles, les couches fonctionnelles comprenant :
une couche barrière de diffusion (104) avec une épaisseur dans une plage d'environ 0,01 micron à environ 0,10 micron comprenant du nitrure de bore déposé sur les fibres de carbure de silicium (102), dans lesquelles la couche barrière de diffusion (104) est déposée en exposant les fibres de carbure de silicium (102) à une atmosphère gazeuse comprenant un écoulement d'un gaz contenant de l'azote et un écoulement d'un gaz contenant du bore à une température dans une plage d'environ 700°C à environ 875°C ;
une couche tolérant l'humidité (106) comprenant du nitrure de bore dopé au silicium déposé sur la couche barrière de diffusion (104), dans laquelle la couche tolérant l'humidité (106) est déposée en introduisant, après que la couche barrière de diffusion (104) soit déposée, un écoulement de gaz contenant du silicium dans l'atmosphère gazeuse, dans laquelle la couche tolérant l'humidité (106) inclut du silicium à une concentration d'environ 2 % atomique à environ 30 % atomique, une épaisseur de la couche tolérant l'humidité (106) étant d'environ 5 à environ 300 fois une épaisseur de la couche barrière de diffusion (104), la couche tolérant l'humidité (106) et la couche barrière de diffusion (104) définissant ensemble une multicouche conforme (108) ; et
une couche de mouillage (110) comprenant du carbure de silicium, du carbure de bore et/ou du carbone pyrolytique déposé sur la multicouche conforme (108).

12. Préforme fibreuse pour fabriquer un composite à matrice céramique, selon la revendication 11, dans laquelle l'épaisseur de la couche barrière de diffusion (104) est dans une plage allant d'environ 0,05 micron à environ 0,10 micron.

13. Préforme fibreuse pour fabriquer un composite à matrice céramique, selon la revendication 11 ou 12, dans laquelle l'épaisseur de la couche tolérant l'humidité (106) est dans une plage allant d'environ 0,4 micron à environ 3 microns.
